# EUROPEAN PATENT APPLICATION

(11) **EP 1 903 419 A1**
(43) Date of publication of application: **26.03.2008**
(21) Application number: 07101748.7
(22) Date of filing: 05.02.2007
(51) Int. Cl.: G06F 1/20

(54) **Printed circuit board unit having void for receiving fan**

(30) Priority: 13.09.2006 JP 2006247607
(71) Applicant: Fujitsu Ltd., Kawasaki-shi, Kanagawa 211-8588 (JP)
(72) Inventor: Iijima, Takashi, Kawasaki-shi Kanagawa 211-8588 (JP)
(74) Representative: Stebbing, Timothy Charles

(57) **Abstract**

A fan (28) has a casing (29) defining a protuberance (45) swelling from a flat surface (36) in an electronic apparatus. An edge of a printed wiring board (22) is contoured to define a recess (43). The recess (43) is shaped to receive the protuberance (45) of the casing. The printed wiring board (22) receives the flat surface (36) of the casing at a position adjacent to the protuberance (45). This results in a reduction in the height of the casing (29) from the upper surface of the printed wiring board (22) as compared with the case where the protuberance is received on the upper surface of the printed wiring board. The thickness of the electronic component (such as a notebook computer) can thus be reduced. As the recess (43) is formed along an edge of the printed wiring board, it is more easily formed as compared with the case where a bore is formed in the printed wiring board.

## Description

The present invention relates to an electronic component (electronic equipment) such as a notebook personal computer.

A printed wiring board is incorporated in a notebook personal computer as described in Japanese Patent Application Publication No.2003-092483,for example. A central processing unit (CPU) package is mounted on the printed wiring board. A heat pipe is utilized to cool the CPU package. The heat pipe is connected to a fan. The fan generates airflow absorbing heat from the heat pipe. The airflow is discharged out of the notebook personal computer. The CPU package is cooled in this manner.

A fan casing is fixed to the upper surface of the printed wiring board. An air inlet is formed in the printed wiring board in the fan casing. It is troublesome to form such an air inlet. In addition, a protuberance is defined in the top plate of the fan casing. The protuberance swells (rises up) from the flat surface of the top plate. The protuberance is defined at a predetermined height from the upper surface of the printed wiring board. Redesign of the printed wiring board and the fan is required for reduction in the thickness of the notebook personal computer.

It is therefore desirable to provide an electronic component and a printed circuit board unit capable of reduction in the thickness.

According to the present invention, there is provided an electronic component comprising: a fan having a casing defining a protuberance swelling from a flat surface of the casing; and a printed wiring board defining a recess to locate the protuberance of the casing inside, the printed wiring board receiving the flat surface of the casing at a position adjacent to the protuberance.

The electronic component allows the recess of the printed wiring board to receive the protuberance of the casing. The printed wiring board receives the flat surface of the casing at a position adjacent to the protuberance. This results in a reduction in the height of the casing from the upper surface of the printed wiring board as compared with the case where the protuberance is received on the upper surface of the printed wiring board, for example. The thickness of the electronic component can be reduced. Moreover, the recess is formed along the contour of the printed wiring board. The recess can be formed in a facilitated manner as compared with the case where a bore is formed in the printed wiring board.

In addition, the printed wiring board receives the flat surface of the casing at a position adjacent to the protuberance as described above. The dimension of the recess can significantly be reduced as compared with the case where a recess larger than the contour of the casing is formed in the printed wiring board. This results in an increase in the surface area of the printed wiring board. The upper and lower surfaces of the printed wiring board allow formation of more electrically-conductive patterns.

The electronic component may further comprise an air inlet defined in the protuberance within the recess. The electronic component may further comprise an electrically-conductive pattern formed on the upper surface of the printed wiring board. In this case, the electrically-conductive pattern maybe designed to receive the casing. More electrically-conductive patterns can be formed on the printed wiring board in this manner. The electronic component may further comprise: a wiring extending from the protuberance; and a small-sized recess formed in the printed wiring board. The small-sized recess may be located within the recess. The small-sized recess may be designed to receive the wiring. A driving unit may be located inside the protuberance of the casing for driving the fan.

There is also provided a printed circuit board unit for use in electronic equipment (to realize the electronic component). The printed circuit board unit may comprise: a fan having a casing defining a protuberance swelling from a flat surface of the casing; and a printed wiring board defining a recess to located the protuberance of the casing inside, the printed wiring board receiving the flat surface of the casing at a position adjacent to the protuberance. The printed circuit board unit of this type significantly contributes to realization of the aforementioned electronic component.

The above and other features and advantages of the present invention will become apparent from the following description of the preferred embodiment in conjunction with the accompanying drawings, wherein:
Fig. 1 is a perspective view schematically illustrating a notebook personal computer as a specific example of an electronic apparatus according to the present invention;
Fig. 2 is a perspective view schematically illustrating the inner structure of a main body enclosure;
Fig. 3 is an enlarged sectional view schematically illustrating a fan;
Fig. 4 is a sectional view taken along the line 4-4 in Fig. 3; and
Fig. 5 is a sectional view, corresponding to Fig. 3, schematically illustrating a recess.

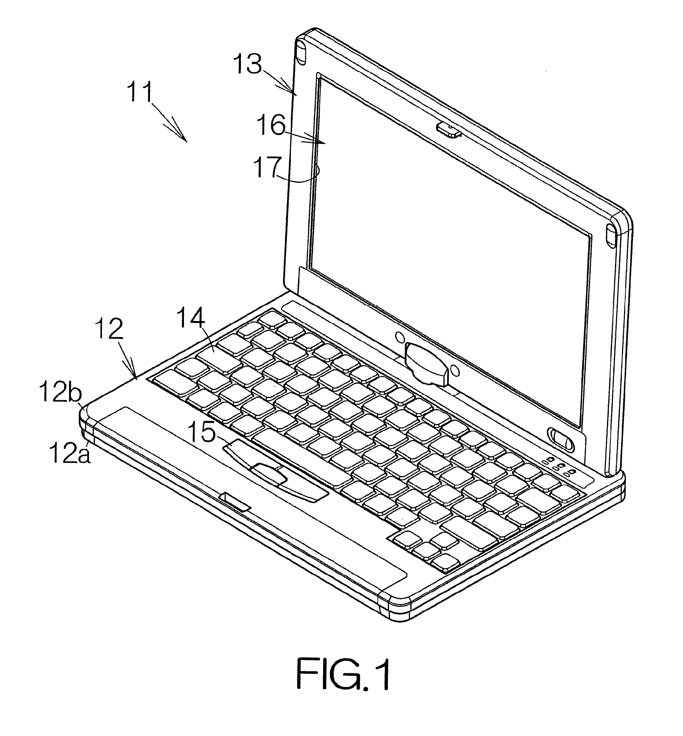

Fig. 1 schematically illustrates a notebook personal computer 11 as a specific example of an electronic apparatus according to the present invention. The notebook personal computer 11 includes a thin first enclosure, namely a main body enclosure 12, and a second enclosure, namely a display enclosure 13. The display enclosure 13 is coupled to the main body enclosure 12 for a relative swinging movement. The main body enclosure 12 includes a base 12a and a cover 12b removably coupled to the base 12a . Input devices such as a keyboard 14 and a pointing device 15 are embedded in the surface of the cover 12b. Users manipulate the keyboard 14 and/or the pointing device 15 to input commands and/or data.

A liquid crystal display (LCD) panel module 16 is enclosed in the display enclosure 13, for example. The screen of the LCD panel module 16 gets exposed in a window opening 17 defined in the display enclosure 13. Text and graphics are displayed on the screen. Users can see the ongoing operation of the notebook personal computer 11 based on the displayed text and graphics. The display enclosure 13 can be superimposed on the main body enclosure 12 through the pivotal movement relative to the main body enclosure 12.

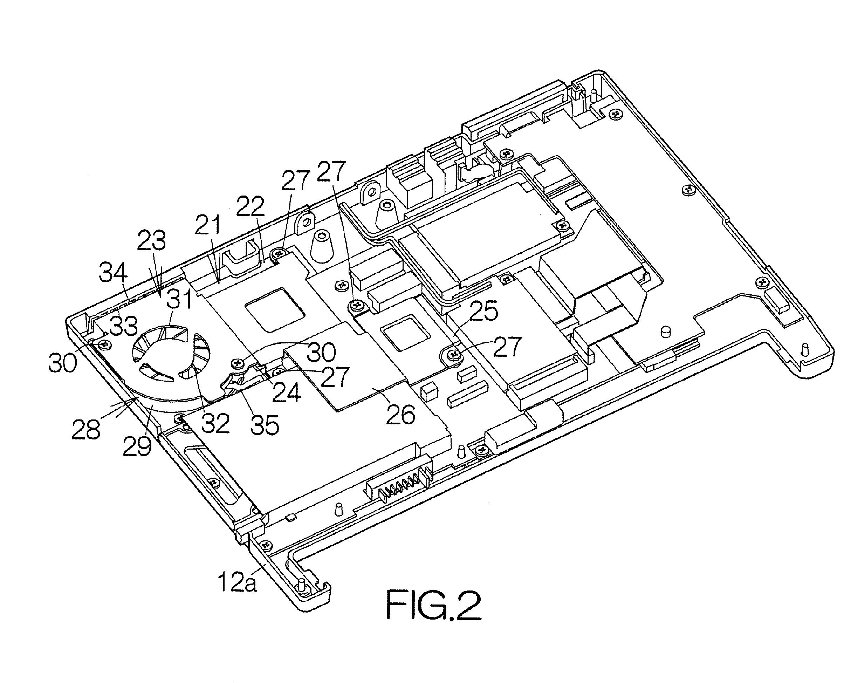

As shown in Fig. 2, a printed circuit board unit or motherboard 21 is enclosed in the main body enclosure 12. A cooling unit 23 is attached to a printed wiring board 22 of the motherboard 21. The cooling unit 23 includes a thermal conductive plate 26 overlaid on a central processing unit (CPU) chip 24 and a video chip 25, for example. A fan 28 is attached to the thermal conductive plate 26. Screws 27 are utilized to fix the thermal conductive plate 26 to the printed wiring board 22, for example. The CPU chip 24 is designed to execute various kinds of processing based on an operating system (OS) and/or application software, for example. The video chip 25 is designed to execute image processing based on the processing of the CPU chip 24, for example.

The fan 28 includes a fan casing 29 attached to the thermal conductive plate 26. Screws 30 may be utilized to attach the fan casing 29. An air inlet 31 is formed in the thermal conductive plate 26. A rotor 32 is placed in the inner space defined in the fan casing 29. A ventilation opening 33 is defined in the fan casing 29. The ventilation opening 33 is opposed to an air outlet 34 defined in the side wall of the base 12a. Airflow generated based on the rotation of the rotor 32 is introduced into the fan casing 29 through the air inlet 31. The airflow is discharged out of the main body enclosure 12 through the ventilation opening 33 and the air outlet 34. Wiring 35 extends at a position adjacent to the fan casing 29.

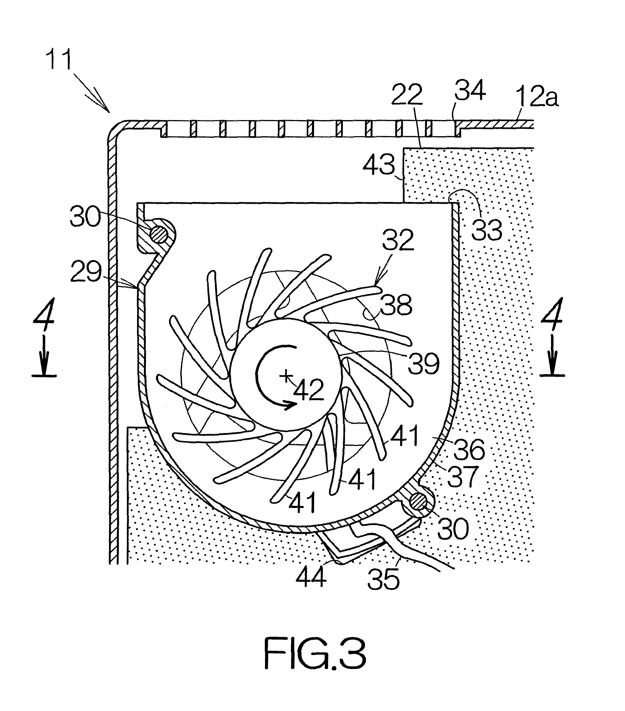

As shown in Fig. 3, the fan casing 29 includes a bottom plate 36 and a surrounding wall 37 standing upright from the surface of the bottom plate 36 at the edge of the bottom plate 36. An air inlet 38 is defined in the bottom plate 36. The rotor 32 includes a rotating body 39 and blades 41 extending in the centrifugal direction from the rotating body 39. When the rotor 32 is driven for rotation around a rotation axis 42, fresh air is introduced along the rotation axis 42 through the air inlets 31, 38. The rotation of the rotor 32 serves to generate airflow running in the centrifugal direction. The thermal conductive plate 26, the bottom plate 36 and the surrounding wall 37 in combination define the aforementioned ventilation opening 33. The ventilation opening 33 is located at a position outward in the centrifugal direction of the rotor 32. The fan 28 serves as a so-called centrifugal fan.

A recess 43 is defined in the printed wiring board 22. The bottom plate 36 of the fan casing 29 is received on the upper surface of the printed wiring board 22 at a position adjacent to the recess 43. The air inlet 38 of the bottom plate 36 is located inside the recess 43. A small-sized recess (narrower recess or groove) 44 is defined in the printed wiring board 22. The small-sized recess 44 is connected to the recess 43. Specifically, the small-sized recess 44 is defined in the edge of the printed wiring board 22 within the recess 43. The small-sized recess 44 extends outside the contour of the fan casing 29. The aforementioned wiring 35 is received in the small-sized recess 44. The wiring 35 is designed to extend into the fan casing 29 through the air inlet 38 of the bottom plate 36. One end of the wiring 35 is connected to an electric motor as described later. The other end of the wiring 35 is connected to the printed wiring board 22 through a connector, not shown, for example.

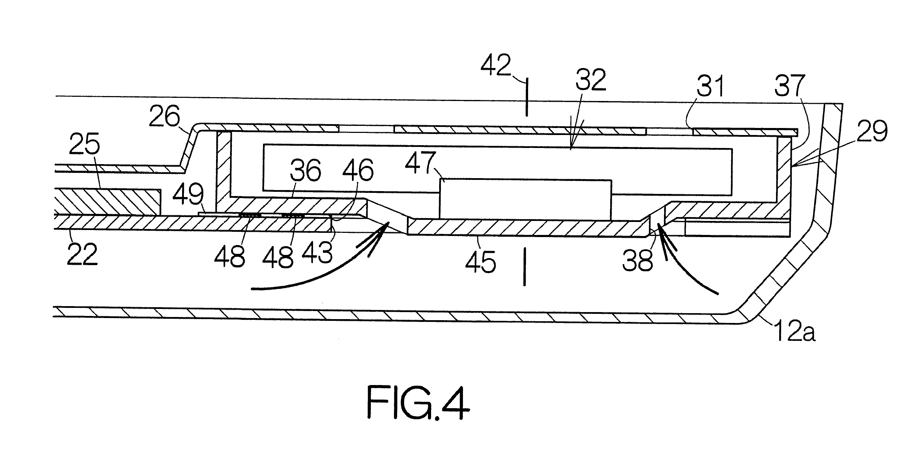

As shown in Fig. 4, a protuberance 45 is defined in the bottom plate 36 of the fan casing 29. The protuberance 45 swells (protrudes or rises) from a flat surface 46 defined in the bottom plate 36 toward the bottom surface of the base 12a, for example. The flat surface 46 may extend along an imaginary plane perpendicular to the rotation axis 42. The protuberance 45 is received in the recess 43 of the printed wiring board 22. The air inlet 38 is formed in the protuberance 45. The printed wiring board 22 receives the flat surface 46 of the bottom plate 36 at a position adjacent to the protuberance 45. A driving unit or electric motor 47 is enclosed in the protuberance 45. The electric motor 47 is designed to drive the rotor 32. The end of the aforementioned wiring 35 is connected to the electric motor 47.

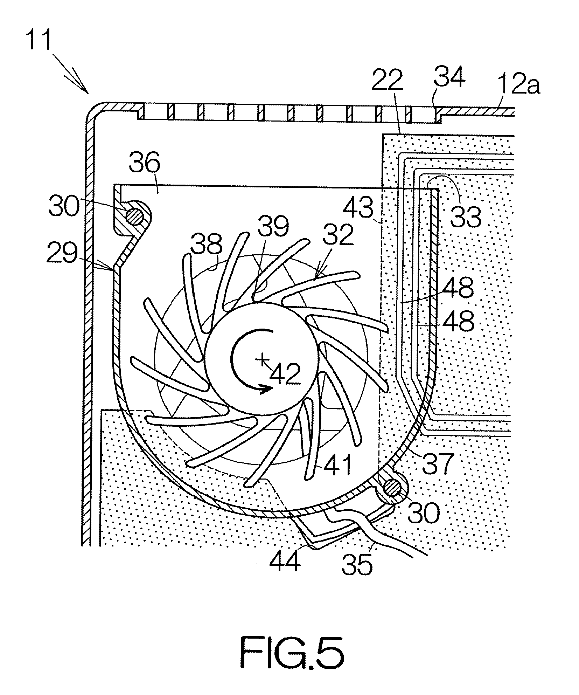

An electrically-conductive pattern 48 is formed on the upper surface of the printed wiring board 22. The electrically-conductive pattern 48 is designed to receive the bottom plate 36 of the fan casing 29. The electrically-conductive pattern 48 serves to connect electronic components one another on the printed wiring board 22. The electronic components may include the CPU chip 24, the video chip 25, and the like, which are mounted on the printed wiring board 22, for example. An insulating sheet 49 covers over the electrically-conductive pattern 48 on the upper surface of the printed wiring board 22. The insulating sheet 49 is interposed between the electrically-conductive pattern 48 and the bottom plate 36. The insulating sheet 49 enables electric insulation between the electrically-conductive pattern 48 and the bottom plate 36. As shown in Fig. 5, the bottomplate 36 may be received on a rib, not shown, standing upright from the bottom plate of the base 12a in the recess 43, for example.

The operating CPU chip 24 and video chip 25 get heated in the notebook personal computer 11. The heat of the CPU chip 24 and the video chip 25 is transferred to the thermal conductive plate 26. The fan 28 is attached to the thermal conductive plate 26. The fan 28 is driven for rotation to introduce fresh air along the rotation axis 42 through the air inlets 31, 38. The rotation of the rotor 32 serves to generate airflow in the centrifugal direction. The airflow absorbs heat from the thermal conductive plate 26. The airflow is discharged out of the main body enclosure 12 through the ventilation opening 33 and the air outlet 34. The CPU chip 24 and the video chip 25 can be cooled in this manner.

The protuberance 45 of the fan casing 29 is received in the recess 43 in the notebook personal computer 11. The printed wiring board 22 receives the flat surface 46 of the fan casing 29 at a position adjacent to the protuberance 45. This results in a reduction of the height of the fan casing 29 from the upper surface of the printed wiring board 22 as compared with the case where the protuberance 45 is received on the upper surface of the printed wiring board 22, for example. The thickness of the main body enclosure 12 or notebook personal computer 11 can be reduced. Moreover, the recess 43 is formed along the contour (edge) of the printed wiring board 22. The recess 43 can be formed in the printed wiring board 22 in a facilitated manner as compared with the case where an opening (through hole) is formed in the printed wiring board 22.

The printed wiring board 22 receives the flat surface 46 of the fan casing 29 at a position adjacent to the protuberance 45 as described above. The dimension of the recess 43 can significantly be reduced as compared with the case where a recess larger than the contour of the fan casing 29 is formed in the printed wiring board 22. This results in increase in the surface area of the printed wiring board 22. The upper and lower surfaces of the printed wiring board 22 allow formation of more electrically-conductive patterns 48. The insulating sheet 49 enables the electrically-conductive pattern 48 to receive the flat surface 46 of the fan casing 29, for example.

Since the printed wiring board 22 receives the flat surface 46 of the fan casing 29 at a position adj acent to the protuberance 45 as described above, no gap is formed between the printed wiring board 22 and the fan casing 29. Airflow generated along the lower surface of the printed wiring board 22 can run through the air inlet 38 with a higher efficiency as compared with the case where a recess larger than the contour of the fan casing 29 is formed in the printed wiring board 22. The electronic components mounted on the lower surface of the printed wiring board 22 can thus be cooled with a higher efficiency.

To summarise, in the present invention, a fan (28) has a casing (29) defining a protuberance (45) swelling from a flat surface (36) in an electronic apparatus. An edge of a printed wiring board (22) is contoured to define a recess (43). The recess (43) is shaped to receive the protuberance (45) of the casing. The printed wiring board (22) receives the flat surface (36) of the casing at a position adjacent to the protuberance (45) . This results in a reduction in the height of the casing (29) from the upper surface of the printed wiring board (22) as compared with the case where the protuberance is received on the upper surface of the printed wiring board. The thickness of the electronic component (such as a notebook computer) can thus be reduced. As the recess (43) is formed along an edge of the printed wiring board, it is more easily formed as compared with the case where a bore is formed in the printed wiring board.

## Claims

1. An electronic component comprising:
a fan having a casing defining a protuberance swelling from a flat surface of the casing; and
a printed wiring board defining a recess to locate the protuberance of the casing inside, the printed wiring board receiving the flat surface of the casing at a position adjacent to the protuberance.

2. The electronic component according to claim 1, further comprising an air inlet defined in the protuberance within the recess.

3. The electronic component according to claim 1 or 2, further comprising an electrically-conductive pattern formed on an upper surface of the printed wiring board, the electrically-conductive pattern receiving the casing.

4. The electronic component according to claim 1, 2 or 3, further comprising a wiring extending from the protuberance; and a small-sized recess formed in the printed wiring board for receiving the wiring, the small-sized recess being connected to the recess.

5. The electronic component according to any preceding claim , further comprising a driving unit located inside the protuberance of the casing for driving the fan.

6. A printed circuit board unit comprising:
a fan having a casing defining a protuberance swelling from a flat surface of the casing; and
a printed wiring board defining a recess to locate the protuberance of the casing inside, the printed wiring board receiving the flat surface of the casing at a position adjacent to the protuberance.

7. The printed circuit board unit according to claim 6 further comprising an air inlet defined in the protuberance within the recess.

8. The printed circuit board unit according to claim 6 or 7 further comprising an electrically-conductive pattern formed on an upper surface of the printed wiring board, the electrically-conductive pattern receiving the casing.

9. The printed circuit board unit according to claim 6, 7 or 8, further comprising a wiring extending from the protuberance; and a small-sized recess formed in the printed wiring board for receiving the wiring, the small-sized recess being connected to the recess.

10. The printed circuit board unit according to any of claims 6 to 9, further comprising a driving unit located inside the protuberance of the casing for driving the fan.
